# EUROPEAN PATENT APPLICATION

(11) **EP 4 683 221 A1**
(43) Date of publication of application: **21.01.2026**
(21) Application number: 23926853.5
(22) Date of filing: 21.03.2023
(51) Int. Cl.: H03H 9/02, H03H 9/25, H03H 9/64, H03H 9/145

(54) **SURFACE ACOUSTIC WAVE RESONATOR AND SURFACE ACOUSTIC WAVE FILTER**

(30) Priority: 15.03.2023 CN 202310252785
(71) Applicant: Maxscend Microelectronics Company Limited, Wuxi, Jiangsu 214000 (CN)
(72) Inventor: SONG, Chongxi, Wuxi, Jiangsu 214000 (CN); WU, Wenjie, Wuxi, Jiangsu 214000 (CN); YAO, Yuan, Wuxi, Jiangsu 214000 (CN); YAO, Yanlong, Wuxi, Jiangsu 214000 (CN); ZHANG, Ning, Wuxi, Jiangsu 214000 (CN); WANG, Fang, Wuxi, Jiangsu 214000 (CN)
(74) Representative: Murgitroyd & Company
(86) International application number: PCT/CN2023/082909
(87) International publication number: WO 2024/187501

(57) **Abstract**

This application relates to a surface acoustic wave resonator and a surface acoustic wave filter, including an interdigital transducer, which includes a first busbar, and first electrode fingers and first dummy electrode fingers alternately arranged and connected to the first busbar; a second busbar, and second electrode fingers and second dummy electrode fingers alternately arranged and connected to the second busbar. A first gap is provided between the first electrode finger and the second dummy electrode. A second gap is provided between the second electrode finger and the first dummy electrode finger. Each first gap is arranged along a first direction. Each second gap is arranged along a second direction. An angle between the first direction and a third direction is different from that between the second direction and the third direction. By setting the angle between the first and third direction to be different from that between the second and third direction in this application, lateral energy leakage in surface acoustic waves can be blocked, transverse mode ripples in the surface acoustic waves can be suppressed, and electrical performance can be improved.

## Description

### TECHNICAL FIELD

This application relates to the field of communications, and in particular, to a surface acoustic wave resonator and a surface acoustic wave filter.

### BACKGROUND

With development of communication technologies, product terminals impose stringent requirements on performance of various components. Filters are key components in communication systems. As technology advances, the types of filters have become increasingly diverse, ranging from LCR filters to cavity filters, and from LTCC ceramic filters to surface acoustic wave filters, indicating continuous technological evolution in filters. Since the advent of the LTE era, surface acoustic wave filters have played an increasingly important role in the communication systems. Meanwhile, with the progression of the communication technologies, the requirements for filters have become increasingly demanding. Particularly with the arrival of the fifth-generation mobile communication technology (5G), the filter industry faces significant challenges and opportunities.

Surface acoustic wave devices based on single-crystal piezoelectric lithium tantalate substrates have been widely used in radio frequency filters. However, limited by the Q factor and high-frequency temperature coefficient of single-crystal piezoelectric materials, it is difficult to meet the requirements of RF front-end chips. Surface acoustic wave resonators and radio frequency filters that still employ traditional designs exhibit strong transverse mode ripples in practical applications, causing severe passband clutter and leading to deterioration in overall device performance.

### SUMMARY

Based on this, it is necessary to provide a surface acoustic wave resonator and a surface acoustic wave filter that suppress transverse mode ripples in surface acoustic waves and improve electrical performance.

A surface acoustic wave resonator, includes:
a substrate layer; and
an electrode layer arranged on the substrate layer, where the electrode layer includes an interdigital transducer,
where the interdigital transducer includes: a first busbar, and first electrode fingers and first dummy electrode fingers that are alternately arranged and connected to the first busbar; a second busbar, and second electrode fingers and second dummy electrode fingers that are alternately arranged and connected to the second busbar; where the first electrode fingers and the second dummy electrode fingers are arranged opposite to each other, with a first gap between the first electrode finger and the second dummy electrode; and the second electrode fingers and the first dummy electrode fingers are arranged opposite to each other, with a second gap between the second electrode finger and the first dummy electrode;
where each first gap is arranged along a first direction, and each second gap is arranged along a second direction, where an angle between the first direction and a third direction is different from an angle between the second direction and the third direction; and in a direction parallel to a plane where the substrate layer is located, the third direction is perpendicular to a length direction of the first electrode finger.

In an embodiment, the third direction and the length direction of the first electrode finger divide a plane into a first quadrant, a second quadrant, a third quadrant, and a fourth quadrant, where the first quadrant and the second quadrant are centrally symmetric, and the third quadrant and the fourth quadrant are centrally symmetric;
both the first direction and the second direction lie within the first quadrant, the second quadrant, the third quadrant, or the fourth quadrant;
or, the first direction lies within one of the first quadrant, the second quadrant, the third quadrant, and the fourth quadrant, and the second direction lies within another quadrant different from the quadrant where the first direction lies;
or, one of the first direction and the second direction is parallel to the third direction, while the other one of the first direction and the second direction is at an angle to the third direction.

In an embodiment, the first electrode fingers and the first dummy electrode fingers are arranged obliquely or perpendicularly to the first busbar;
and/or, the second electrode fingers and the second dummy electrode fingers are arranged obliquely or perpendicularly to the second busbar.

In an embodiment, the first busbar, the first electrode fingers, the first dummy electrode fingers, the second busbar, the second electrode fingers, and the second dummy electrode fingers together form a connection piece, a plurality of such connection pieces are provided, which are connected in sequence and arranged in a predetermined shape.

In an embodiment, the angle between the first direction and the third direction is different for each connection piece; the angle between the second direction and the third direction is different for each connection piece.

In an embodiment, there are two connection pieces, where the first busbars of the two connection pieces are connected to each other, and the second busbars of the two connection pieces are connected to each other; and the predetermined shape is a polyline shape.

In an embodiment, the predetermined shape includes a linear linear arrangement, a polyline shape, or a polygon.

In an embodiment, the angle between the first direction and the third direction is α, and the angle between the second direction and the third direction is β, where an absolute value of a difference between α and β ranges from 0.2° to 3°.

In an embodiment, one end of the first electrode finger adjacent to the second dummy electrode finger is provided with a first thickened portion, and one end of the second electrode finger adjacent to the first dummy electrode finger is provided with a second thickened portion; one end of the first dummy electrode finger adjacent to the second electrode is provided with a third thickened portion, and one end of the second dummy electrode finger adjacent to the first electrode finger is provided with a fourth thickened portion.

This application further provides a surface acoustic wave filter, including the aforementioned surface acoustic wave resonator.

In the above solution, by setting the angle between the first direction and the third direction to be different from the angle between the second direction and the third direction, the lateral energy leakage in surface acoustic waves can be blocked, transverse mode ripples in the surface acoustic waves can be suppressed, and electrical performance can be improved.

### BRIEF DESCRIPTION OF THE DRAWINGS

FIG. 1 is a schematic structure diagram of a surface acoustic wave resonator provided by an embodiment of the present invention.
FIG. 2 is a schematic structure diagram of an interdigital transducer provided by another embodiment of the present invention.
FIG. 3 is a schematic structure diagram of an interdigital transducer provided by another embodiment of the present invention.
FIG. 4 is a schematic structure diagram of an interdigital transducer provided by another embodiment of the present invention.
FIG. 5 is a schematic structural diagram of an interdigital transducer provided by another embodiment of the present invention.
FIG. 6 is a schematic structural diagram of an interdigital transducer provided by another embodiment of the present invention.
FIG. 7 is a schematic structural diagram of an interdigital transducer provided by another embodiment of the present invention.
FIG. 8 is a schematic structural diagram of an interdigital transducer provided by another embodiment of the present invention.
FIG. 9 is a simulation diagram showing a possible simulation of an interdigital transducer shown in FIG. 1 provided by an embodiment of the present invention.

### Reference numeral explanation:

10, surface acoustic wave resonator; 100, electrode layer; 110, interdigital transducer (IDT); 111, first busbar; 112, first electrode finger; 113, first dummy electrode finger; 114, second busbar; 115, second electrode finger; 116, second dummy electrode finger; 117, first gap; 118, second gap; 120, connection piece; 130, reflector grating structure; 131, third busbar; 132, fourth busbar; 133, reflection grating; a, first direction; b, second direction; c, third direction.

### DETAILED DESCRIPTION OF THE EMBODIMENTS

To make the above objectives, features, and advantages of this application more clearly understood, the specific implementations of this application are described in detail below with reference to the accompanying drawings. Many specific details are set forth in following description to facilitate a full understanding of this application. However, this application may be implemented in many other ways different from those described herein. Those skilled in the art may make similar improvements without departing from the spirit of this application, and therefore this application is not limited by specific embodiments disclosed below.

In the description of this application, it should be understood that if terms such as "center", "longitudinal", "transverse", "length", "width", "thickness", "upper", "lower", "front", "rear", "left", "right", "vertical", "horizontal", "top", "bottom", "inner", "outer", "clockwise", "counterclockwise", "axial", "radial", and "circumferential" appear, orientations or positional relationships indicated by these terms are based on the orientations or the positional relationships shown in the drawings. They are used only to facilitate the description of this application and simplify the description, rather than to indicate or imply that the referred apparatus or element must have a specific orientation or be constructed and operated in a specific orientation. Therefore, they should not be understood as a limitation to this application.

In addition, if terms such as "first" and "second" appear, they are used for descriptive purpose only and should not be understood as indicating or implying relative importance or implicitly specifying the number of the indicated technical features. Thus, features defined by "first" or "second" may explicitly or implicitly include at least one such features. In the description of this application, if the term "a plurality of" appears, it means at least two, such as two, three, etc., unless otherwise specifically defined.

In this application, unless explicitly specified and defined otherwise, if terms such as "mount", "connect", "join" and "fixed" appear, they should be broadly interpreted. For example, it may be a fixed connection, a detachable connection, or an integral connection; it may be a mechanical connection or an electrical connection; and it may be a direct connection or an indirect connection via an intermediate medium, or it may be an internal communication between two elements or an interaction relationship between two elements, unless otherwise explicitly defined. Those of ordinary skill in the art can understand the specific meanings of these terms in this application based on the specific context.

In this application, unless explicitly specified and defined otherwise, if descriptions such as a first feature being "on" or "under" a second feature appear, it may mean that the first feature and the second feature are in direct contact, or that the first feature and the second feature are in indirect contact via an intermediate medium. Moreover, the first feature being "above", "over", or "on" the second feature may mean that the first feature is directly above or obliquely above the second feature, or merely indicates that the horizontal level of the first feature is higher than that of the second feature. The first feature being "below", "under", and "beneath" the second feature may mean that the first feature is directly below or obliquely below the second feature, or merely indicates that the horizontal level of the first feature is lower than that of the second feature.

It should be noted that if an element is referred to as being "fixed to" or "arranged on" another element, it may be directly on the other element, or an intervening element may be present. If an element is considered to be "connected" to another element, it may be directly connected to the other element, or an intervening element may be present simultaneously. If present, terms such as "vertical", "horizontal", "upper", "lower", "left", "right", and similar expressions used in this application are for illustrative purposes only and do not represent the only implementation.

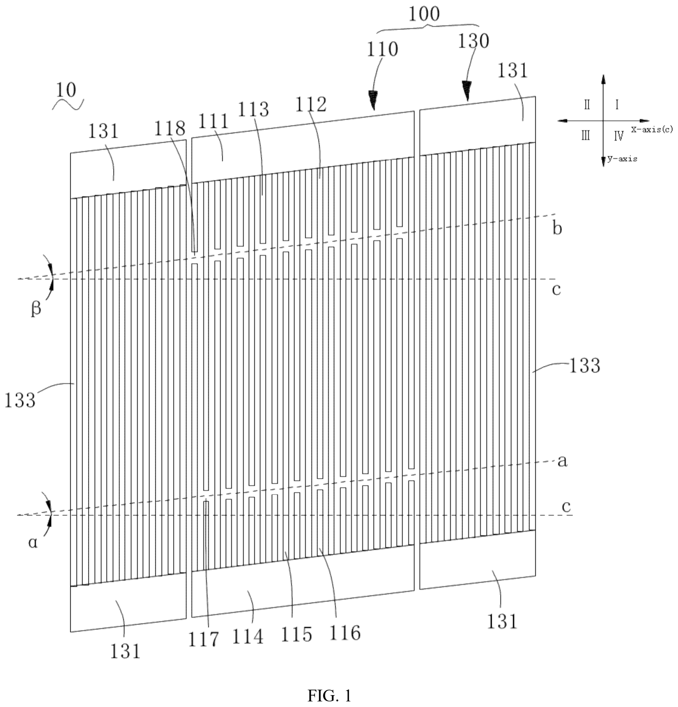

Please refer to FIG. 1, FIG. 2, and FIG. 3, an embodiment of the present invention provides a surface acoustic wave resonator 10 that includes a substrate layer and an electrode layer 100 arranged on the substrate layer. Specifically, the surface acoustic wave resonator 10 further includes a piezoelectric layer arranged on the substrate layer, with the electrode layer 100 located on a side of the piezoelectric layer away from the substrate layer.

Exemplarily, the material of the substrate layer may be high-resistance silicon. The high-resistance silicon may be P-type high-resistance silicon or N-type high-resistance silicon. The resistivity of the high-resistance silicon is greater than 2000 Ω·cm, and preferably, the resistivity of the high-resistance silicon is greater than 10000 Ω·cm. The material of the piezoelectric layer may be lithium tantalate and lithium niobate, where a cut angle of the lithium tantalate may range from 30° to 50°, and a thickness of the piezoelectric layer may range from 300 nm to 1000 nm. The electrode layer 100 is formed by depositing a metal film on a surface of the piezoelectric layer via methods such as electron beam evaporation, plasma deposition, or magnetron sputtering. The material for depositing the metal film may be titanium, chromium, copper, silver, aluminum, etc., or combinations thereof.

Please refer to FIG. 1, FIG. 2, and FIG. 3, the electrode layer 100 includes an interdigital transducer 110. The interdigital transducer 110 includes: a first busbar 111, and first electrode fingers 112 and first dummy electrode fingers 113 that are alternately arranged and connected to the first busbar 111; a second busbar 114, and second electrode fingers 115 and second dummy electrode fingers 116 that are alternately arranged and connected to the second busbar 114. The first electrode fingers 112 and the second dummy electrode fingers 116 are arranged opposite to each other, with a first gap 117 between the first electrode finger 112 and the second dummy electrode. The second electrode fingers 115 and the first dummy electrode fingers 113 are arranged opposite to each other, with a second gap 118 between the second electrode finger 115 and the first dummy electrode.

Each first gap 117 is arranged along a first direction "a", and each second gap 118 is arranged along a second direction "b". An angle between the first direction "a" and a third direction "c" is different from an angle between the second direction "b" and the third direction "c". In a direction parallel to a plane where the substrate layer is located, the third direction "c" is perpendicular to a length direction of the first electrode finger 112. By setting the angle between the first direction "a" and the third direction "c" to be different from the angle between the second direction "b" and the third direction "c", lateral energy leakage in surface acoustic waves can be blocked, transverse mode ripples in the surface acoustic waves can be suppressed, and electrical performance can be improved.

Specifically, the quantities of the first electrode fingers 112, the second electrode fingers 115, the first dummy electrode fingers 113, and the second electrode fingers 115 are arranged in a one-to-one correspondence. That is, the quantities of the first electrode fingers 112, the second electrode fingers 115, the first dummy electrode fingers 113, and the second electrode fingers 115 are all the same.

Please refer to FIG. 1, FIG. 2, FIG. 3, FIG. 4, FIG. 5, and FIG. 6, according to some optional embodiments of this application, the third direction "c" and the length direction of the first electrode finger 112 divide a plane into a first quadrant, a second quadrant, a third quadrant, and a fourth quadrant. The first quadrant and the second quadrant are centrally symmetric, and the third quadrant and the fourth quadrant are centrally symmetric. Specifically, an intersection point of the third direction "c" and the length direction of the first electrode finger 112 serves as a origin of the quadrants. The third direction "c" serves as an X-axis of the quadrants, the length direction of the first electrode finger 112 serves as a Y-axis of the quadrants.

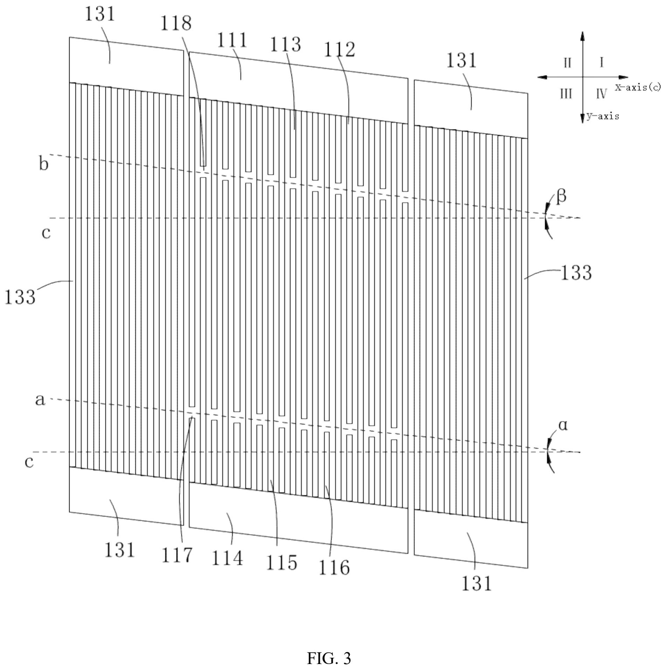

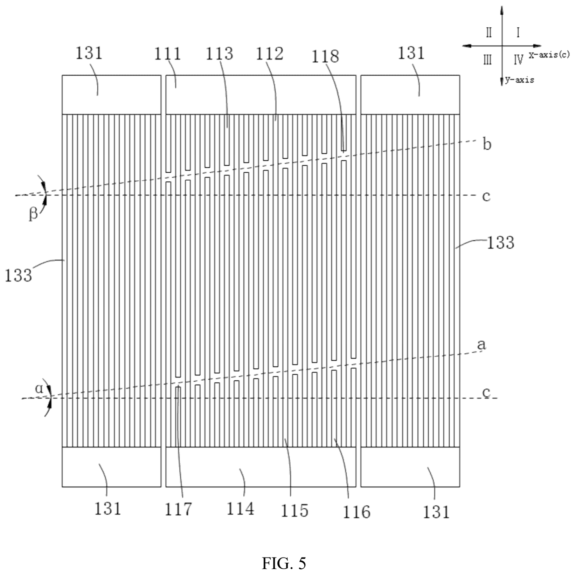

In an embodiment, both the first direction "a" and the second direction "b" lie within the first quadrant, the second quadrant, the third quadrant, or the fourth quadrant. Specifically, in a first embodiment, as shown in FIG. 1 and FIG. 5, both the first direction "a" and the second direction "b" lie within the first quadrant. Accordingly, an angle between the first direction "a" and the third direction "c", and an angle between the second direction "b" and the third direction "c", each range from 0° to 90°. In a second embodiment, as shown in FIG. 3, both the first direction "a" and the second direction "b" lie within the second quadrant. Accordingly, the angle between the first direction "a" and the third direction "c", and the angle between the second direction "b" and the third direction "c", each range from 90° to 180°. In a third embodiment, both the first direction "a" and the second direction "b" lie within the third quadrant. Accordingly, the angle between the first direction "a" and the third direction "c", and the angle between the second direction "b" and the third direction "c", each range from 180° to 270°. In a fourth embodiment, both the first direction "a" and the second direction "b" lie within the fourth quadrant. Accordingly, the angle between the first direction "a" and the third direction "c", and the angle between the second direction "b" and the third direction "c", each range from 270° to 360°.

In another embodiment, the first direction "a" lies within one of the first quadrant, the second quadrant, the third quadrant, and the fourth quadrant, while the second direction "b" lies within another quadrant different from the quadrant where the first direction "a" lies.

Specifically, in a fifth embodiment, the first direction "a" lies within the first quadrant, while the second direction "b" lies within the second quadrant. Accordingly, the angle between the first direction "a" and the third direction "c" ranges from 0° to 90°, while the angle between the second direction "b" and the third direction "c" ranges from 90° to 180°.

In a sixth embodiment, the first direction "a" lies within the first quadrant, while the second direction "b" lies within the third quadrant. Accordingly, the angle between the first direction "a" and the third direction "c" ranges from 0° to 90°, while the angle between the second direction "b" and the third direction "c" ranges from 180° to 270°.

In a seventh embodiment, the first direction "a" lies within the first quadrant, while the second direction "b" lies within the fourth quadrant. Accordingly, the angle between the first direction "a" and the third direction "c" ranges from 0° to 90°, while the angle between the second direction "b" and the third direction "c" ranges from 270° to 360°.

In an eighth embodiment, the first direction "a" lies within the second quadrant, while the second direction "b" lies within the third quadrant. Accordingly, the angle between the first direction "a" and the third direction "c" ranges from 90° to 180°, while the angle between the second direction "b" and the third direction "c" ranges from 180° to 270°.

In a ninth embodiment, the first direction "a" lies within the second quadrant, while the second direction "b" lies within the fourth quadrant. Accordingly, the angle between the first direction "a" and the third direction "c" ranges from 90° to 180°, while the angle between the second direction "b" and the third direction "c" ranges from 270° to 360°.

In a tenth embodiment, the first direction "a" lies within the third quadrant, while the second direction "b" lies within the fourth quadrant. Accordingly, the angle between the first direction "a" and the third direction "c" ranges from 180° to 270°, while the angle between the second direction "b" and the third direction "c" ranges from 270° to 360°.

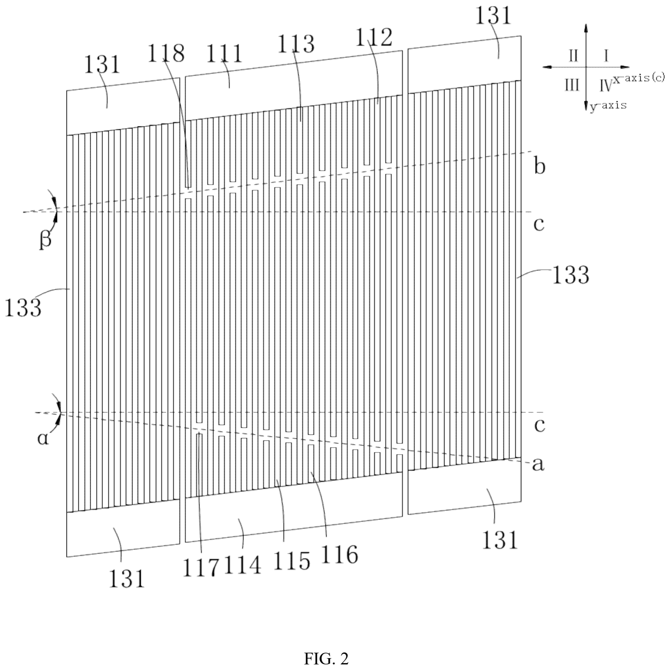

In an eleventh embodiment, as shown in FIG. 2, the first direction "a" lies within the fourth quadrant, while the second direction "b" lies within the first quadrant. Accordingly, the angle between the first direction "a" and the third direction "c" ranges from 270° to 360°, while the angle between the second direction "b" and the third direction "c" ranges from 0° to 90°.

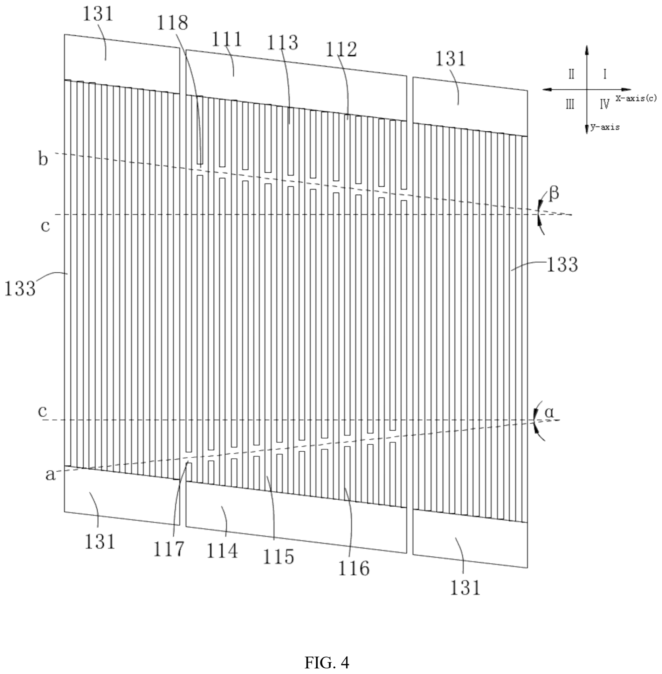

In a twelfth embodiment, as shown in FIG. 4, the first direction "a" lies within the third quadrant, while the second direction "b" lies within the second quadrant. Accordingly, the angle between the first direction "a" and the third direction "c" ranges from 180° to 270°, while the angle between the second direction "b" and the third direction "c" ranges from 90° to 180°.

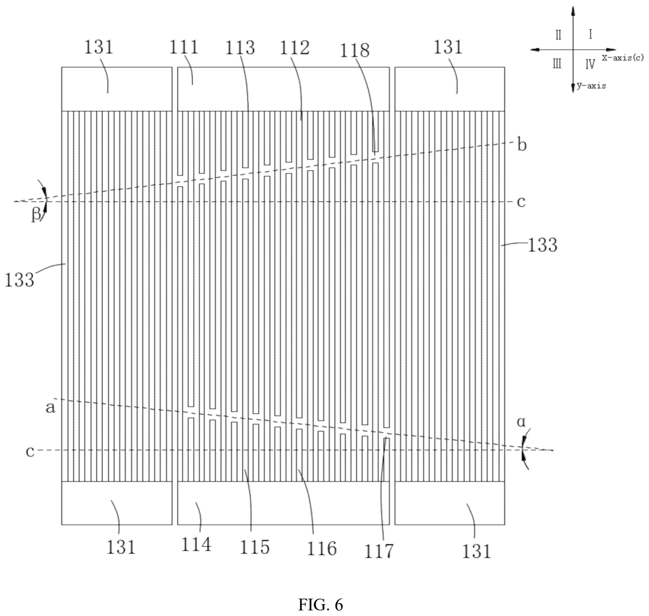

In a thirteenth embodiment, as shown in FIG. 6, the first direction "a" lies within the second quadrant, while the second direction "b" lies within the first quadrant. Accordingly, the angle between the first direction "a" and the third direction "c" ranges from 90° to 180°, while the angle between the second direction "b" and the third direction "c" ranges from 0° to 90°.

In yet another embodiment, one of the first direction "a" and the second direction "b" is parallel to the third direction "c", while the other one of the first direction "a" and the second direction "b" is at an angle to the third direction "c". In this embodiment, the angle between the one of the first direction "a" and the second direction "b" and the third direction "c" is 0°.

Please refer to FIG. 1 to FIG. 6, according to some optional embodiments of this application, the first electrode fingers 112 and the first dummy electrode fingers 113 are arranged obliquely or perpendicularly to the first busbar 111. The second electrode fingers 115 and the second dummy electrode fingers 116 are arranged obliquely or perpendicularly to the second busbar 114.

Specifically, in a first embodiment, as shown in FIG. 5 and FIG. 6, the first electrode fingers 112 and the first dummy electrode fingers 113 are arranged perpendicularly to the first busbar 111. The second electrode fingers 115 and the second dummy electrode fingers 116 are arranged perpendicularly to the second busbar 114. In this embodiment, an extending direction of the first busbar 111 and an extending direction of the second busbar 114 are both parallel to the third direction "c".

In another embodiment, please refer to FIG. 1, FIG. 2, FIG. 3, and FIG. 4, the first electrode fingers 112 and the first dummy electrode fingers 113 are arranged obliquely to the first busbar 111. The second electrode fingers 115 and the second dummy electrode fingers 116 are arranged obliquely to the second busbar 114. It should be understood that this application does not limit the inclination angles of the first electrode fingers 112 and the first dummy electrode fingers 113 relative to the first busbar 111, or the inclination angles of the second electrode fingers 115 and the second dummy electrode fingers 116 relative to the second busbar 114, these angles may be set according to usage requirements.

Exemplarily, the inclination angles of the first electrode fingers 112 and the first dummy electrode fingers 113 relative to the first busbar 111, and the inclination angles of the second electrode fingers 115 and the second dummy electrode fingers 116 relative to the second busbar 114, may be equal to the angle between the first direction "a" and the third direction "c", or may be equal to the angle between the second direction "b" and the third direction "c", which are not limited in this application.

Pleas refer to FIG. 1, FIG. 2, FIG. 7, and FIG. 8, according to some optional embodiments of this application, the first busbar 111, the first electrode fingers 112, the first dummy electrode fingers 113, the second busbar 114, the second electrode fingers 115, and the second dummy electrode fingers 116 together form a connection piece 120. A plurality of such connection pieces 120 are provided, which are connected in sequence and arranged in a predetermined shape. The quantity of connection pieces 120 is not limited in this application and may be set according to usage requirements.

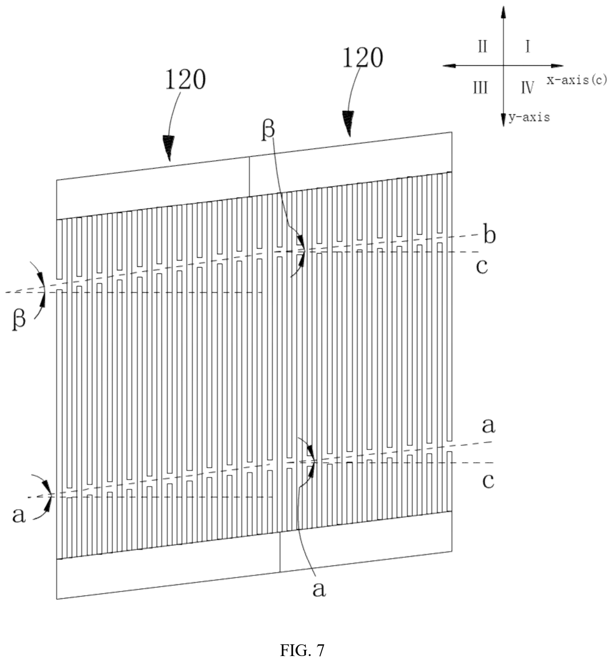

Specifically, as shown in FIG. 7, the angle between the first direction "a" and the third direction "c" is different for each connection piece 120. The angle between the second direction "b" and the third direction "c" is different for each connection piece 120. By setting different angles between the first direction "a" and the third direction "c", and between the second direction "b" and the third direction "c", for each connection piece 120, lateral energy leakage in the surface acoustic wave may be further blocked, transverse mode ripples in the surface acoustic wave may be suppressed, and the electrical performance may be improved.

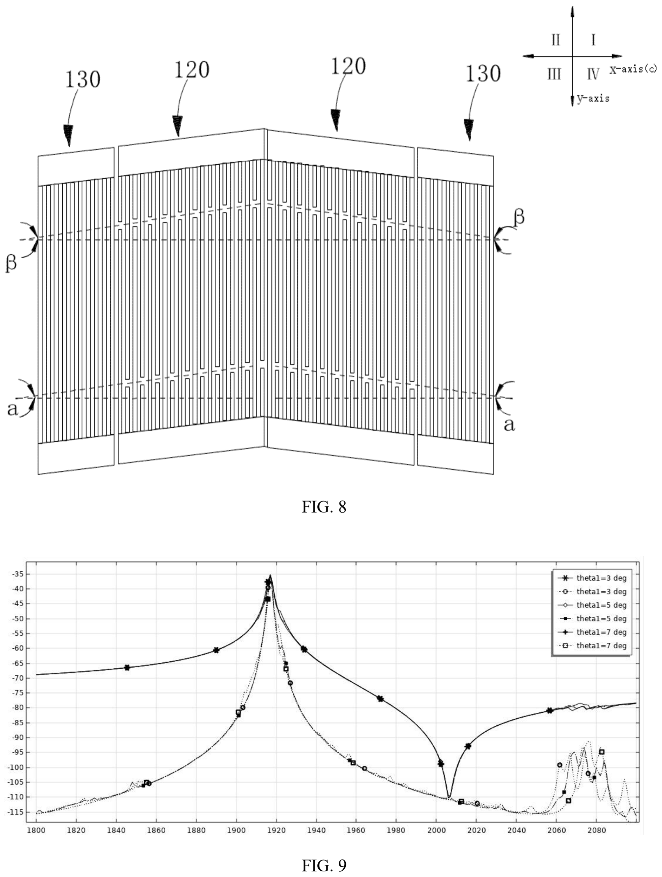

In an embodiment, as shown in FIG. 8, there are two connection pieces 120. The first busbars 111 of the two connection pieces 120 are connected to each other, and the second busbars 114 of the two connection pieces 120 are connected to each other, and the predetermined shape is a polyline shape. Specifically, an angle is present between the first busbars 111 of the two connection pieces 120.

In another embodiment, the predetermined shape includes a linear arrangement, a polyline shape, or a polygon. For example, the predetermined shape may be an equilateral triangular arrangement, a right-angled triangular arrangement, or shapes such as a diamond, square, rectangle, or trapezoid. The number of the connection pieces 120 may also be five, six, or even more.

Please refer to FIG. 1, FIG. 2, FIG. 3, and FIG. 4, according to some optional embodiments of this application, the angle between the first direction "a" and the third direction "c" is α, and the angle between the second direction "b" and the third direction "c" is β, where an absolute value of a difference between α and β ranges from 0.2° to 3°.

Specifically, the angle α between the first direction "a" and the third direction "c" ranges from 0° to 12°. The angle β between the second direction "b" and the third direction "c" ranges from 0° to 12°. It should be noted that this application does not specifically limit the value of the angle α between the first direction "a" and the third direction "c", or the value of the angle β between the second direction "b" and the third direction "c". The angle α between the first direction "a" and the third direction "c" may be selected from within a range of 0° to 12°, and the angle β between the second direction "b" and the third direction "c" may be selected from within a range of 0° to 12°. It should be noted that when the angle α between one direction and the third direction "c" is 0°, the angle β between the second direction "b" and the third direction "c" is not 0°.

The angle α between the first direction "a" and the third direction "c" may be greater than the angle β between the second direction "b" and the third direction "c", or the angle α between the first direction "a" and the third direction "c" may be less than the angle β between the second direction "b" and the third direction "c". This application imposes no limitation in this regard, as long as the absolute value of the difference between α and β falls within the range of 0.2° to 3°. For example, the angle α between the first direction "a" and the third direction "c" is 8°, and the angle β between the second direction "b" and the third direction "c" is 6°.

Please refer to FIG. 1 and FIG. 2, according to some optional embodiments of this application, one end of the first electrode finger 112 adjacent to the second dummy electrode finger 116 is provided with a first thickened portion. One end of the second electrode finger 115 adjacent to the first dummy electrode finger 113 is provided with a second thickened portion. One end of the first dummy electrode finger 113 adjacent to the second electrode is provided with a third thickened portion. One end of the second dummy electrode finger 116 adjacent to the first electrode finger 112 is provided with a fourth thickened portion.

The first thickened portion, the second thickened portion, the third thickened portion, and the fourth thickened portion have identical dimensions. In the third direction "c", a width of the first thickened portion is greater than a width of the first electrode finger 112, a width of the second thickened portion is greater than a width of the second electrode finger 115, a width of the third thickened portion is greater than a width of the first dummy electrode finger 113, and a width of the fourth thickened portion is greater than a width of the second dummy electrode finger 116.

By arranging the first thickened portion, the second thickened portion, the third thickened portion, and the fourth thickened portion, lateral energy leakage in the surface acoustic wave can be blocked, spurious modes in the surface acoustic wave can be suppressed, and Q factor of the surface acoustic wave resonator 10 can be improved. For example, shapes of the first thickened portion, the second thickened portion, the third thickened portion, and the fourth thickened portion may be rectangular in shape. Alternatively, they may also be triangular, polygonal, or recessed in shape.

Specifically, the first thickened portion and the fourth thickened portion are arranged opposite to each other, and the second thickened portion and the third thickened portion are arranged opposite to each other. This configuration can further block the lateral energy leakage in the surface acoustic wave, suppress the spurious modes in the surface acoustic wave, and further improve the Q factor of the surface acoustic wave resonator 10.

Please refer to FIG. 1, FIG. 2, and FIG. 8, according to some optional embodiments of this application, the electrode layer 100 further includes reflector grating structures 130. The reflector grating structure 130 includes a third busbar 131, a fourth busbar 132, and reflection gratings 133. The third busbar 131 and the fourth busbar 132 are arranged in parallel. A first end of the reflection grating 133 is connected to the third busbar 131, and a second end of the reflection grating 133 is connected to the fourth busbar 132. Specifically, the third busbar 131 and the fourth busbar 132 are arranged perpendicularly to the reflection gratings 133.

Each of two opposite sides of the interdigital transducer 110 is provided with a reflector grating structure 130. The reflector grating structure 130 is capable of reflecting energy of the surface acoustic wave, thereby concentrating the energy within the interdigital transducer 110. Specifically, the reflection gratings 133 are arranged parallel to the first electrode fingers 112, the first dummy electrode fingers 113, the second electrode fingers 115, and the second dummy electrode fingers 116. This further ensures that the reflector grating structure 130 concentrates the reflected surface acoustic wave energy into the interdigital transducer 110, thereby further increasing the Q factor of the surface acoustic wave resonator 10.

For the IDT electrode shown in FIG. 1, please refer to FIG. 9, which shows a possible simulation diagram of the IDT electrode. As shown in FIG. 9, taking β=8°, and α=3°, 5°, or 7° as examples, the curves marked with "*", "◇", and "+" in the figure represent an admittance magnitude at the respective values of α, while the curves marked with "∘", " 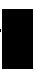 ", and "□" represent a real part of the admittance, i.e., a conductance at the respective values of α. It may be seen from the figure that by setting values of β and α to be different, in-band transverse modes may be effectively suppressed, thereby achieving an effect of suppressing transverse modes.

This application further provides a surface acoustic wave filter, including the aforementioned surface acoustic wave resonator 10. Specifically, the surface acoustic wave filter provided in the embodiments of this application has corresponding beneficial effects as the surface acoustic wave resonator 10 described in any embodiment of this application. Technical details not exhaustively described in this embodiment can be found in any embodiment of the surface acoustic wave resonator 10 in this application.

The various technical features of the embodiments described above may be arbitrarily combined. For the sake of brevity, not all possible combinations of the technical features in the above embodiments have been described. However, as long as there is no contradiction in the combination of these technical features, they should be considered to fall within the scope recorded in this specification.

The above-mentioned embodiments merely represent several implementations of this application, and the description thereof is relatively specific and detailed, but should not therefore be construed as limiting the patent scope of the application. It should be pointed out that those skilled in the art may make several modifications and improvements without departing from the concept of this application, and these all fall within the protection scope of this application. Therefore, the protection scope of this patent application shall be defined by the appended claims.

## Claims

1. A surface acoustic wave resonator, **characterized by** comprising:
a substrate layer; and
an electrode layer arranged on the substrate layer, wherein the electrode layer comprises an interdigital transducer,
wherein the interdigital transducer comprises: a first busbar, and first electrode fingers and first dummy electrode fingers that are alternately arranged and connected to the first busbar; a second busbar, and second electrode fingers and second dummy electrode fingers that are alternately arranged and connected to the second busbar; wherein the first electrode fingers and the second dummy electrode fingers are arranged opposite to each other, with a first gap between the first electrode finger and the second dummy electrode; and the second electrode fingers and the first dummy electrode fingers are arranged opposite to each other, with a second gap between the second electrode finger and the first dummy electrode;
wherein each first gap is arranged along a first direction, and each second gap is arranged along a second direction, wherein an angle between the first direction and a third direction is different from an angle between the second direction and the third direction; and in a direction parallel to a plane where the substrate layer is located, the third direction is perpendicular to a length direction of the first electrode finger.

2. The surface acoustic wave resonator according to claim 1, **characterized in that**, the third direction and the length direction of the first electrode finger divide a plane into a first quadrant, a second quadrant, a third quadrant, and a fourth quadrant, wherein the first quadrant and the second quadrant are centrally symmetric, and the third quadrant and the fourth quadrant are centrally symmetric;
both the first direction and the second direction lie within the first quadrant, the second quadrant, the third quadrant, or the fourth quadrant;
or, the first direction lies within one of the first quadrant, the second quadrant, the third quadrant, and the fourth quadrant, while the second direction lies within another quadrant different from the quadrant where the first direction lies;
or, one of the first direction and the second direction is parallel to the third direction, while the other one of the first direction and the second direction is at an angle to the third direction.

3. The surface acoustic wave resonator according to claim 1, **characterized in that**, the first electrode fingers and the first dummy electrode fingers are arranged obliquely or perpendicularly to the first busbar;
and/or, the second electrode fingers and the second dummy electrode fingers are arranged obliquely or perpendicularly to the second busbar.

4. The surface acoustic wave resonator according to claim 1, **characterized in that**, the first busbar, the first electrode fingers, the first dummy electrode fingers, the second busbar, the second electrode fingers, and the second dummy electrode fingers together form a connection piece, a plurality of such connection pieces are provided, which are connected in sequence and arranged in a predetermined shape.

5. The surface acoustic wave resonator according to claim 4, **characterized in that**, the angle between the first direction and the third direction is different for each connection piece; the angle between the second direction and the third direction is different for each connection piece.

6. The surface acoustic wave resonator according to claim 4, **characterized in that**, there are two connection pieces, wherein the first busbars of the two connection pieces are connected to each other, and the second busbars of the two connection pieces are connected to each other; and the predetermined shape is a polyline shape.

7. The surface acoustic wave resonator according to claim 4, **characterized in that**, the predetermined shape comprises a linear linear arrangement, a polyline shape, or a polygon.

8. The surface acoustic wave resonator according to claim 1, **characterized in that**, the angle between the first direction and the third direction is α, and the angle between the second direction and the third direction is β, wherein an absolute value of a difference between α and β ranges from 0.2° to 3°.

9. The surface acoustic wave resonator according to claim 1, **characterized in that**, one end of the first electrode finger adjacent to the second dummy electrode finger is provided with a first thickened portion, and one end of the second electrode finger adjacent to the first dummy electrode finger is provided with a second thickened portion; one end of the first dummy electrode finger adjacent to the second electrode is provided with a third thickened portion, and one end of the second dummy electrode finger adjacent to the first electrode finger is provided with a fourth thickened portion.

10. A surface acoustic wave filter, **characterized by** comprising the surface acoustic wave resonator according to any one of claims 1 to 9.
